# EUROPÄISCHE PATENTSCHRIFT

(11) **EP 0 585 806 B1**
(45) Veröffentlichungstag und Bekanntmachung des Hinweises auf die Patenterteilung: **23.07.1997**
(21) Anmeldenummer: 93113625.3
(22) Anmeldetag: 26.08.1993
(51) Int. Cl.: H03L 7/085, G01R 25/08, H03D 13/00

(54) **Digitaler Phasenkomparator und Phasenregelkreis**
Digital phase comparator and phase-locked loop
Comparateur de phase numérique et boucle à verrouillage de phase

(30) Priorität: 01.09.1992 DE 4229148
(43) Veröffentlichungstag der Anmeldung: 09.03.1994
(73) Patentinhaber: Alcatel SEL Aktiengesellschaft, D-70435 Stuttgart (DE)
(72) Erfinder: Rieder, Klaus-Hartwig, D-70195 Stuttgart (DE)
(74) Vertreter: Brose, Gerhard, Dipl.-Ing.

(56) Entgegenhaltungen:
- WO-A-90/03693
- US-A- 3 989 931
- PATENT ABSTRACTS OF JAPAN vol. 4, no. 148 (E-030) 18. Oktober 1980 & JP-A-55 100 739 (MITSUBUSHI ELECTRIC CORP.) 31. Juli 1980
- PROCEEDINGS OF THE IEEE, Bd.72, Nr.3, März 1984, NEW YORK US Seiten 397 - 398 T. S. RATHORE ET AL. 'AN ACCURATE DIGITAL PHASE MEASUREMENT SCHEME'
- U. TIETZE ET AL. 'HALBLEITER-SCHALTUNGSTECHNIK' 1986 , SPRINGER-VERLAG , BERLIN

## Beschreibung

Die Erfindung betrifft einen digitalen Phasenkomparator nach dem Oberbegriff des Anspruchs 1 und einen Phasenregelkreis.

Ein solcher Phasenkomparator ist bekannt aus DE 40 25 307 A1. Dabei wird im Prinzip der zeitliche Abstand zwischen zwei gleichphasigen Punkten der zu vergleichenden Signale gemessen. Bei den dort vorausgesetzten Analogsignalen wird der Phasenunterschied der Nulldurchgänge ermittelt. Sind Digitalsignale zu vergleichen, so sind die Flanken die Bezugspunkte. Werden steigende Nulldurchgänge oder Flanken des einen Signals mit abfallenden Nulldurchgängen oder Flanken des anderen Signals verglichen, so sind dem ermittelten Phasenunterschied noch 180 Grad hinzuzuaddieren, was für manche Anwendungsfälle erwünscht sein kann. Bei dem bekannten Komparator öffnet dasjenige Signal ein Tor, dessen Bezugsphase zuerst auftritt; das andere Signal schließt dieses Tor wieder. Ein Zähler zählt die dazwischenliegenden Impulse eines Zeittakts. Der Zeittakt ist bei dem bekannten Beispiel mit einem der beiden Signale, das als Referenzsignal dient, derart verkoppelt, daß seine Frequenz ein ganzes Vielfaches der Frequenz des Referenzsignals ist. Ist beispielsweise die Frequenz des Zeittakts das 360-fache der Frequenz des Referenzsignals, so geben die gezählten Impulse direkt den Phasenunterschied in Grad an.

Bei dem genannten Komparator ist der kleinste meßbare Phasenunterschied ein Grad. Eine feinere Auflösung kann nur durch Erhöhung der Impulsfolgefrequenz des Zeittakts erfolgen. Dem sind aber verhältnismäßig enge Grenzen gesetzt. Außerdem tritt beim bekannten Komparator bei kleinen Phasenunterschieden das Problem der Koinzidenzunterdrückung auf, was ebenfalls der Messung kleinster Unterschiede entgegensteht.

Der Erfindung liegt die Aufgabe zugrunde, einen Phasenkomparator zu schaffen, der auch noch kleine Phasenunterschiede zufriedenstellend erfaßt und einen Phasenregelkreis, der auch noch kleine Phasenunterschiede zufriedenstellend ausregelt. Die Aufgabe wird gelöst durch einen digitalen Phasenkomparator nach der Lehre des Anspruchs 1 und einen Phasenregelkreis nach der Lehre des Anspruchs 5.

Die Verwendung zweier gleich aufgebauter Zweige mit nachfolgender Differenzbildung zur Lösung des Problems der Koinzidenzunterdrückung ist für Vorwärts-Rückwärts-Zähler bekannt aus U. Tietze, Ch. Schenk, Halbleiter-Schaltungstechnik, Achte Auflage, Springer-Verlag 1986, S. 247. Dadurch, daß die beiden Zähler zwar durch je eines der beiden zu vergleichenden Signale freigegeben werden, dann aber erst durch ein Hilfssignal gemeinsam wieder gesperrt werden, ist sichergestellt, daß die Meßzeiten der Zähler so lang sind, daß auftretende Zähltaktimpulse überhaupt erfaßbar sind. Die Tatsache, daß die Zähler überhaupt auf auftretende Zähltaktimpulse ansprechen, ist eine wichtige Voraussetzung dafür, daß sie bei geringen Phasenunterschieden zumindest gelegentlich auch unterschiedlich viele Impulse zählen.

Phasenkomparatoren sind in der Regel Bestandteil eines Phasenregelkreises, der die Phase eines Signals so regelt, daß sie einen vorgegebenen Bezug zur Phase eines Referenzsignals aufweist. Phasenregelkreise enthalten üblicherweise auch ein Element mit zeitlich glättender Wirkung, im analogen Fall in der Regel einen Tiefpass. Diese Mittelung kann beim Aufbau des Phasenkomparators berücksichtigt werden. Es genügt deshalb, wenn kleine Phasenunterschiede sich nur gelegentlich bei der Messung bemerkbar machen. Es ist aber allgemein bekannt, daß eine Erhöhung der Meßgenauigkeit durch wiederholte Messungen und anschließende Mittelwertbildung nur dann erreichbar ist, wenn systematische Meßfehler vermieden werden. Durch die getrennte Messung der Phasendifferenzen der zwei Signale gegenüber einem dritten Signal und die Differenzbildung daraus ergibt sich eine gewisse Entkopplung, die der Vermeidung systematischer Meßfehler dient.

Das Hilfssignal kann im einfachsten Fall aus den beiden zu vergleichenden Signalen gewonnen werden (Anspruch 2).

Ist die Frequenz des Zeittakts kein ganzzahliges Vielfaches der Frequenz der zu vergleichenden Signale, so ergibt sich eine weitere starke Entkopplung zwischen dem Phasenkomparator als Meßanordnung und den Signalen als Meßobjekt. Diese starke Entkopplung hat eine deutliche Verringerung systematischer Meßfehler zur Folge (Anspruch 3).

Die Mittelwertbildung kann im Phasenkomparator selbst in einfacher Weise im Zusammenhang mit der ohnehin erforderlichen Differenzbildung erfolgen, beispielsweise dadurch, daß erst nach einer Vielzahl von Meßzyklen überhaupt eine Differenzbildung erfolgt (Anspruch 4).

Im folgenden wird die Erfindung anhand eines Ausführungsbeispiels unter Zuhilfenahme der beiliegenden Zeichnungen weiter erläutert.
- Fig. 1: zeigt ein Blockschaltbild eines erfindungsgemäßen Phasenkomparators.
- Fig. 2: zeigt Zeitverläufe für den Phasenkomparator nach Fig. 1.
- Fig. 3: zeigt einen Phasenregelkreis mit einem Phasenkomparator nach Fig. 1.

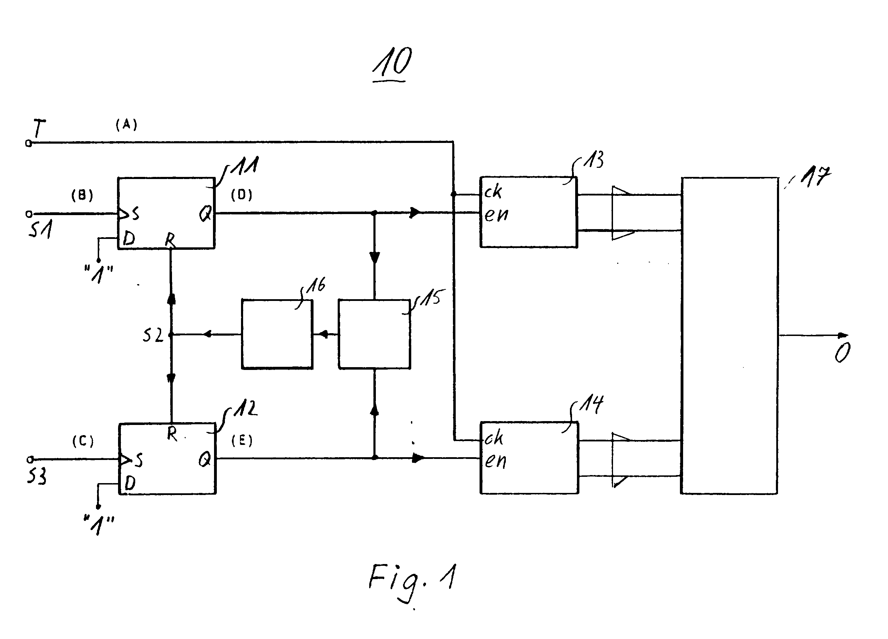

Der Phasenkomparator 10 nach Fig. 1 weist zwei bistabile Kippstufen, nämlich ein Flipflop 11 und ein Flipflop 12, zwei Zähler 13 und 14, eine aus einem UND-Gatter 15 und einer Verzögerungsstufe 16 bestehende Logikschaltung und eine Auswerteeinheit 17 auf.

Die beiden Flipflops 11 und 12 weisen je einen Dateneingang D, einen Takteingang T, einen Rücksetzeingang R und einen Ausgang Q auf. Die Zähler 13 und 14 weisen je einen Takteingang ck und einen Freigabeeingang en auf. Die parallelen Datenausgänge der Zähler sind durch je einen von den Zählern zur Auswerteeinheit 17 verlaufenden Bus angedeutet. Die Busse sind zwar mit Richtungspfeiler versehen, in Gegenrichtung laufende Rücksetzleitungen sollen aber nicht ausgeschlossen werden.

Die bezüglich ihrer Phase zu vergleichenden Signale S1 und S3 liegen an den Takteingängen S der Flipflops 11 bzw. 12 an. Die Dateneingänge D beider Flipflops sind ständig mit dem Pegel verbunden, der dem logischen Wert "1" entspricht. Die Takteingänge S wirken damit wie dynamische Setzeingänge. Die den Rücksetzeingängen R entsprechenden Setzeingänge sind nicht oder so beschaltet, daß sie sich nicht auswirken. Die Ausgänge Q der Filpflops sind mit den Freigabeeingängen der Zähler 13 bzw. 14 verbunden, so daß ein gesetztes Flipflop den zugehörigen Zähler freigibt und ein nicht gesetztes Flipflop den zugehörigen Zähler sperrt. An die Takteingänge ck der Zähler 13 und 14 ist ein Zeittakt T angelegt. Die Frequenz des Zeittakts T sollte hoch sein gegenüber der Frequenz der beiden zu vergleichenden Signale S1 und S3. (Ein Phasenvergleich zwischen zwei Signalen setzt voraus, daß zumindest deren Sollfrequenz gleich ist.) Je größer der Frequenzunterschied zwischen Zeittakt T einerseits und den Signalen S1 und S3 andererseits ist, desto feiner sind die Phasenunterschiede bereits durch eine Einzelmessung erfaßbar. Die vorliegende Schaltung ist für den Einsatz in einer Vermittlungsstelle entwickelt worden. Die Frequenz der beiden Signale S1 und S3 liegt bei 4 kHz. Der Zeittakt T wird aus einem vorhandenen Takt von 10 MHz mittels eines Teilers gewonnen, der durch die Primzahl 23 teilt. Die sich ergebende Frequenz von etwa 430 kHz ist eine gute Grundlage für die weitere Verarbeitung.

Die Eingänge des UND-Gatters 15 sind mit den Ausgängen Q der Flipflops 11 und 12 verbunden. Das Ausgangssignal des UND-Gatters 15 wird durch die Verzögerungsstufe 16 verzögert und bildet ein Hilfssignal S2, das an die Rücksetzeingänge R der beiden Filpflops angelegt ist. Die Verzögerungszeit der Verzögerungsstufe 16 ist mindestens so groß zu wählen, daß ein Zähler, der einmal freigegeben ist, mindestens so lange frei bleibt, wie er braucht, um auf einen anliegenden Taktimpuls zu reagieren. Gerade bei den hier besonders zu berücksichtigenden sehr geringen Phasenunterschieden sind die diesen Phasenunterschieden entsprechenden Zeiten, die mit dem Zeittakt zu vergleichen sind, sehr kurz. Sie sollen sogar kürzer sein als ein einzelner Taktimpuls. Andererseits muß an einem Zähler auch keine komplette Impulsperiode anliegen, damit der Zähler weiterzählt. Ein Zähler reagiert vielmehr, je nach Bautyp, bereits auf eine ansteigende oder eine abfallende Flanke des Zeittakts. Da aber einerseits eine solche Flanke nicht ideal ist (rampenähnlicher Übergang statt eines Sprungs) und andererseits ein Zähler eine bestimmte Mindestreaktionszeit braucht, muß die Verzögerungsstufe 16 eine gewisse Mindestfreigabezeit für die Zähler gewährleisten. Dabei ist zu berücksichtigen, daß auch die Flipflops 11 und 12, das UND-Gatter 15 und die Zähler 13 und 14 gewisse Mindestverzögerungen aufweisen. Die Verzögerungsstufe 16 kann eine Delay Line, ein Schieberegister, ein Monoflop oder eine Folge von Invertern sein, unter Umständen auch ganz entfallen, wenn die übrigen Verzögerungen nicht unbedeutend sind.

Eine über das Minimum hinausgehende Mindestfreigabezeit ist prinzipiell nicht störend. Deshalb kann auch ein Hilfssignal S2 zum Rücksetzen der Flipflops 11 und 12 verwendet werden, das zwar etwa die Frequenz der Signale S1 und S3 aufweist, aber einen anderen Ursprung hat. Wichtig jedenfalls ist, daß das Hilfssignal S2 so weitgehend wie möglich von den Signalen S1 und S3 und vom Zeittakt T entkoppelt ist. Die Mindestverzögerungszeit soll aus praktischen Gründen nicht zu lang sein, weil dadurch der Meßbereich reduziert wird und weil dies die Zähler durch eine Art Grundlast unnötig belastet.

Im oben genannten Beispiel für den Einsatz in einer Vermittlungsstelle, bei dem der Zeittakt T eine Frequenz von ca. 430 kHz und die Signale S1 und S3 eine Frequenz von 4 kHz aufweisen, wurde eine Verzögerung von 200 ns gewählt; die Zähler 13 und 14 sind 16-Bit-Binärzähler, deren Reaktionszeiten bei etwa 50 ns liegen.

Die Ausgänge der Zähler 13 und 14 sind mit der Auswerteeinheit 17 verbunden, so daß dieser die Zählerstände zugänglich sind. Die Auswerteeinheit 17 wertet nun die Zählerstände derart aus, daß sie, z.B. mittels eines digitalen Inverters und eines digitalen Addierers, die Differenz bildet und als digitales Ausgangssignal 0 zur Verfügung stellt. Dies kann nach jeder Einzelmessung, beispielsweise durch das Hilfssignal S2, veranlaßt werden. Anschließend veranlaßt die Auswerteeinheit 17 das Rücksetzen der Zähler 13 und 14. Statt die Zähler rückzusetzen könnte auch der letzte Zählerstand gespeichert und vom nächsten subtrahiert werden.

Bevorzugt veranlaßt die Auswerteeinheit 17 jedoch erst nach einer Vielzahl von Messungen eine Auswertung der Zählerstände. Dazu kann beispielsweise das Hilfssignal S2 mittels eines Teilers durch 100 geteilt werden. Dies führt dann zu einer Mittelwertbildung über 100 Messungen. Sofern die Einzelmessungen wie oben dargelegt, ausreichend gegeneinander entkoppelt sind, ergibt sich damit auch eine Verringerung des Meßfehlers auf ein Hundertstel. Der Teilungsfaktor sowie das Verhältnis der Frequenzen des Zeittakts T und der Signale S1 und S3 haben eine ganz bestimmte, sehr feine Auflösung des Messergebnisses zur Folge.

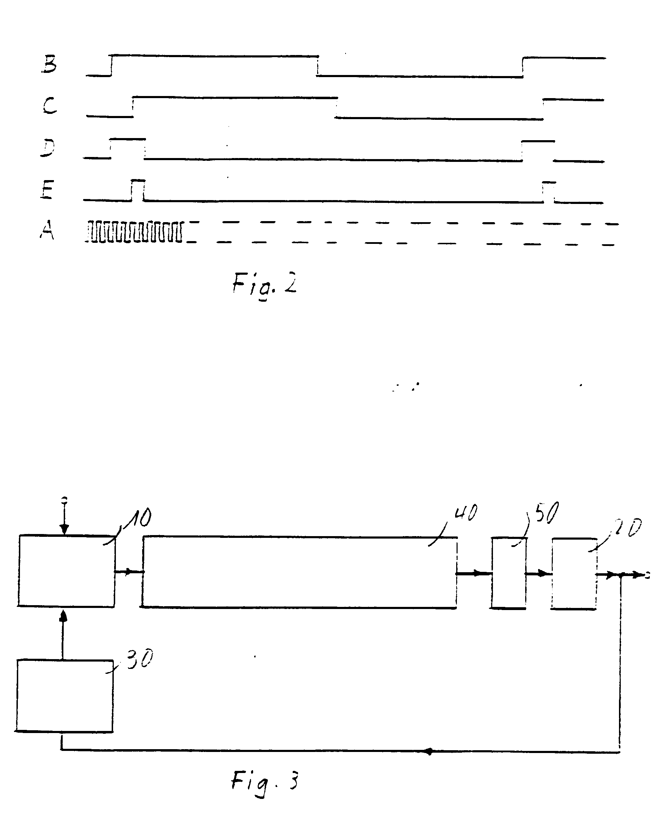

Im vorliegenden Beispiel erfolgt die Auswertung durch Interrupt-Steuerung mittels eines Mikroprozessors alle 100 ms. Dabei ergibt sich eine Auflösung von 5,8 ns.
Anhand der Figur 2 wird noch kurz die Wirkungsweise des Phasenkomparators nach Figur 1 erläutert. Gezeigt sind Zeitverläufe A, B, C, D und E.

Mit B und C sind hier die zu vergleichenden Signale S1 und S3 bezeichnet, die an den Takteingängen S der Flipflops 11 bzw. 12 anliegen. Mit D bzw. E sind die Signale an den entsprechenden Ausgängen Q bezeichnet, die zur Freigabe der Zähler 13 bzw. 14 verwendet werden. Mit A ist hier der Zeittakt T bezeichnet.

Im dargestellten Beispiel eilt das Signal C gegenüber dem Signal B nach. Das Freigabesignal D wird deshalb früher gesetzt als das Freigabesignal E. Beide werden aber gleichzeitig (mittels der Verzögerungsstufe) zurückgesetzt. Der Zähler 13 ist damit für etwa vier Impulse des Zeittakts freigegeben, der Zähler 14 dagegen für etwa zwei Impulse.

Bei 100 Messungen zählt nun der Zähler 13 beispielsweise 54 mal vier Impulse, sonst nur drei und weist am Schluß den Zählerstand 354 auf. Der Zähler 14 zählt dagegen in der gleichen Zeit 76 mal zwei Impulse und sonst nur einen und hat am Schluß den Zählerstand 176. In diesem Beispiel ergibt sich eine Differenz von 178 und ein Mittelwert von 1,78. Der Phasenunterschied beträgt damit 1,78 mal die Periodendauer des Zeittakts T.

Anhand der Figur 3 wird nun noch ein Phasenregelkreis beschrieben, der einen Phasenkomparator 10 wie bereits beschrieben aufweist. Außer dem Phasenkomparator 10 weist der Phasenregelkreis noch einen spannungsgesteuerten Oszillator 20, einen Teiler 30, eine Regelstrecke 40 und einen Digital-Analog-Umsetzer 50 auf.

Bis auf die erfindungsspezifische Ausgestaltung und den wegen der digitalen Auswertung erforderlichen Digital-Analog-Umsetzer ist dies der übliche Aufbau eines Phasenregelkreises.

Der spannungsgesteuerte Oszillator 20 ist für die gewünschte Sollfrequenz dimensioniert. Sein Ausgangssignal, das auch nach außen abgegeben wird, wird im Teiler 30 so geteilt, daß es im Phasenkomparator 10 mit einer Referenzfrequenz verglichen werden kann. Die Regelstrecke 40 sorgt für das gewünschte Regelverhalten. Sie enthält einen Proportionalzweig mit einem Multiplizierer, der das Proportionalverhalten bestimmt, womit laufend die aktuellen Abweichungen ausgeregelt werden und einen Integralzweig, der das Integrationsverhalten bestimmt, womit längerfristig (hier mit einer Zeitkonstante von einigen hundert bis mehreren tausend Sekunden) noch übrigbleibende kleinere Abweichungen aufsummiert und damit letztlich auch noch berücksichtigt werden können. Ein Differentialanteil, durch den auf kurzfristige Abweichungen schnell reagiert werden könnte ist hier nicht vorgesehen. Der Integralzweig ist als Multiplizierer mit nachfolgendem Addierer und Register ausgeführt. Das Register führt den Ausgangswert des Addierers auf dessen einen Eingang zurück, sodaß er zum Ausgangswert des Multiplizierers des Integralzweiges hinzuaddiert wird. Die Ausgangswerte des Proportionalzweigs und des Integralzweigs werden durch einen weiteren Addierer addiert und bilden den Ausgangswert der Regelstrecke, durch den nach Analogisierung Frequenz und Phase des spannungsgesteuerten Oszillators in bekannter Weise nachgeregelt werden.

## Patentansprüche

1. Digitaler Phasenkomparator (10) mit einer bistabilen Kippstufe (11), die durch einen bestimmten Phasenübergang eines ersten Signals (S1) setzbar und durch einen bestimmten Phasenübergang eines zweiten Signals (S2) rücksetzbar ist und mit einem Zähler (13), der durch die bistabile Kippstufe (11) freigegeben wird, solange diese gesetzt ist und an dessen Takteingang (ck) ein Zeittakt (T) anliegt, dessen Frequenz hoch ist gegenüber den Frequenzen des ersten Signals (S1) und des zweiten Signals (S2), **dadurch gekennzeichnet,** daß eine zweite bistabile Kippstufe (12) vorhanden ist, die durch einen bestimmten Phasenübergang eines dritten Signals (S3) setzbar und gemeinsam mit der (ersten) bistabilen Kippstufe (11) rücksetzbar ist, mit einem zweiten Zähler (14), der durch die zweite bistabile Kippstufe (12) freigegeben wird, solange diese gesetzt ist und an dessen Takteingang (ck) der Zeittakt (T) anliegt, daß eine Auswerteeinheit (17) vorhanden ist, die aus den Zählerständen der beiden Zähler durch Differenzbildung einen Bezugswert für die Phasendifferenz zwischen dem ersten Signal (S1) und dem dritten Signal (S3) bildet, und daß das zweite Signal (S2) ein Hilfssignal ist, dessen Frequenz angenähert der Frequenz des ersten Signals (S1) und des dritten Signals (S3) gleicht.

2. Phasenkomparator nach Anspruch 1, dadurch gekennzeichnet, daß eine Logikschaltung vorhanden ist, die das zweite Signal (S2) durch UND-Verknüpfung (15) und nachfolgende Verzögerung (16) aus den Signalen an den beiden Ausgängen der bistabilen Kippstufen (11, 12) bildet.

3. Phasenkomparator nach Anspruch 1, dadurch gekennzeichnet, daß die Frequenz des Zeittakts (T) kein ganzzahliges Vielfaches der Frequenz des ersten Signals (S1) und des dritten Signals (S3) ist.

4. Phasenkomparator nach Anspruch 1, dadurch gekennzeichnet, daß die Auswerteeinheit (17) eine Mittelwertbildung über mehrere Phasendifferenzen bildet.

5. Phasenregelkreis mit einem digitalen Phasenkomparator (10) mit einer bistabilen Kippstufe (11), die durch einen bestimmten Phasenübergang eines ersten Signals (S1) setzbar und durch einen bestimmten Phasenübergang eines zweiten Signals (S2) rücksetzbar ist und mit einem Zähler (13), der durch die bistabile Kippstufe (11) freigegeben wird, solange diese gesetzt ist und an dessen Takteingang (ck) ein Zeittakt (T) anliegt, dessen Frequenz hoch ist gegenüber den Frequenzen des ersten Signals (S1) und des zweiten Signals (S2), **dadurch gekennzeichnet,** daß eine zweite bistabile Kippstufe (12) vorhanden ist, die durch einen bestimmten Phasenübergang eines dritten Signals (S3) setzbar und gemeinsam mit der (ersten) bistabilen Kippstufe (11) rücksetzbar ist, mit einem zweiten Zähler (14), der durch die zweite bistabile Kippstufe (12) freigegeben wird, solange diese gesetzt ist und an dessen Takteingang (ck) der Zeittakt (T) anliegt, daß eine Auswerteeinheit (17) vorhanden ist, die aus den Zählerständen der beiden Zähler durch Differenzbildung einen Bezugswert für die Phasendifferenz zwischen dem ersten Signal (S1) und dem dritten Signal (S3) bildet, und daß das zweite Signal (S2) ein Hilfssignal ist, dessen Frequenz angenähert der Frequenz des ersten Signals (S1) und des dritten Signals (S3) gleicht.

## Claims

1. A digital phase comparator (10) with a bistable flip-flop (11) which is settable by a given phase transition of a first signal (S1), and is resettable by a given phase transition of a second signal (S2), and a counter (13) which is released by the bistable flip-flop (11) as long as the latter is set, and whose clock input (ck) has a time pulse (T) whose frequency is high when compared to the frequencies of the first signal (S1) and the second signal (S2), characterized in that a second bistable flip-flop (12) is provided, which is settable by a given phase transition of a third signal (S3), and is resettable together with the (first) bistable flip-flop (11), with a second counter (14) which is released by the second bistable flip-flop (12) as long as the latter is set and whose clock input (ck) has a time pulse (T), that an evaluation unit (17) is provided which forms a reference value for the phase difference between the first signal (S1) and the third signal (S3) by calculating the difference between the counter statuses of both counters, and that the second signal (S2) is an auxiliary signal whose frequency approximately equals the frequency of the first signal (S1) and the third signal (S3).

2. A phase comparator as claimed in claim 1,
characterized in that a logic circuit is provided which forms the AND-junction (15) and a subsequent delay (16) from the signals at the two outputs of the bistable flip-flops (11, 12).

3. A phase comparator as claimed in claim 1,
characterized in that the frequency of the time pulse (T) is not an integral multiple of the frequency of the first signal (S1) and the third signal (S3).

4. A phase comparator as claimed in claim 1,
characterized in that the evaluation unit (17) forms an average from several phase differences.

5. A phase-locked loop with a digital phase comparator (10) with a bistable flip-flop (11) which is settable by a given phase transition of a first signal (S1), and is resettable by a given phase transition of a second signal (S2), and with a counter (13) which is released by the bistable flip-flop (11) as long as the latter is set, and has a time pulse (T) at its clock input (ck) whose frequency is high when compared to the frequencies of the first signal (S1) and the second signal (S2), characterized in that a second bistable flip-flop (12) is provided which is settable by a given phase transition of a third signal (S3), and is resettable together with the (first) bistable flip-flop (11), and with a second counter (14) which is released by the second bistable flip-flop (12) as long as he latter is set and has a time pulse (T) at its clock input (ck), that an evaluation unit (17) is provided which forms a reference value for the phase difference between the first signal (S1) and the third signal (S3) by calculating the difference between the counter statuses of both counters, and that the second signal (S2) is an auxiliary signal whose frequency approximately equals the frequency of the first signal (S1) and the third signal (S3).

## Revendications

1. Comparateur de phase numérique (10) comportant un étage à bascule bistable (11), qui peut être positionné au moyen d'une transition déterminée de phase d'un premier signal (S1) et peut être ramené à l'état initial par une transition déterminée de phase d'un second signal (S2), et comportant un compteur (13), qui est libéré par l'étage à bascule bistable (11), tant que ce dernier est positionné, et à l'entrée de cadence (ck) duquel est appliquée une cadence temporelle (T), dont la fréquence est élevée par rapport aux fréquences du premier signal (S1) et du second signal (S2), caractérisé en ce qu'il est prévu un second étage à bascule bistable (12), qui peut être positionné par une transition déterminée de phase d'un troisième signal (S3) et peut être ramené à l'état initial conjointement avec le (premier) étage à bascule bistable (11) et un second compteur (14), qui est libéré par le second étage à bascule bistable (12) tant que ce dernier est positionné, et à l'entrée de cadence (ck) duquel est appliquée la cadence temporelle (T), qu'il est prévu une unité d'exploitation (17) qui à partir des états des deux compteurs forme, par formation d'une différence, une valeur de référence pour la différence de phase entre le premier signal (S1) et le troisième signal (S3), et que le second signal (S2) est un signal auxiliaire, dont la fréquence est égale approximativement à la fréquence du premier signal (S1) et du troisième signal (S3).

2. Comparateur de phase selon la revendication 1, caractérisé en ce qu'il est prévu un circuit logique, qui forme le second signal (S2) par combinaison ET (15) et retardement ultérieur (16) à partir des signaux présents sur les deux sorties des étages à bascule bistable (11, 12).

3. Comparateur de phase selon la revendication 1, caractérisé en ce que la fréquence de la cadence temporelle (T) n'est pas un multiple entier de la fréquence du premier signal (S1) et du troisième signal (S3).

4. Comparateur de phase selon la revendication 1, caractérisé en ce que l'unité d'exploitation (17) exécute une formation de la valeur moyenne sur plusieurs différences de phase.

5. Circuit de régulation de phase comportant un comparateur de phase numérique (10) comportant un étage à bascule bistable (11), qui peut être positionné au moyen d'une transition déterminée de phase d'un premier signal (S1) et peut être ramené à l'état initial par une transition déterminée de phase d'un second signal (S2), et comportant un compteur (13), qui est libéré par l'étage à bascule bistable (11), tant que ce dernier est positionné, et à l'entrée de cadence (ck) duquel est appliquée une cadence temporelle (T), dont la fréquence est élevée par rapport aux fréquences du premier signal (S1) et du second signal (S2), caractérisé en ce qu'il est prévu un second étage à bascule bistable (12), qui peut être positionné par une transition déterminée de phase d'un troisième signal (S3) et peut être ramené à l'état initial conjointement avec le (premier) étage à bascule bistable (11), et un second compteur (14), qui est libéré par le second étage à bascule bistable (12) tant que ce dernier est positionné, et à l'entrée de cadence (ck) duquel est appliquée la cadence temporelle (A), qu'il est prévu une unité d'exploitation (17) qui, à partir des états des deux compteurs forme, par formation d'une différence, une valeur de référence pour la différence de phase entre le premier signal (S1) et le troisième signal (S3), et que le second signal (S2) est un signal auxiliaire, dont la fréquence est égale approximativement à la fréquence du premier signal (S1) et du troisième signal (S3).
